# EUROPEAN PATENT APPLICATION

(11) **EP 4 117 404 A1**
(43) Date of publication of application: **11.01.2023**
(21) Application number: 21465534.2
(22) Date of filing: 08.07.2021
(51) Int. Cl.: H05K 7/20, F28D 15/00

(54) **THERMAL DIODE AND COOLING METHOD**

(71) Applicant: Continental Automotive Technologies GmbH, 30165 Hannover (DE)
(72) Inventor: Miron, Liviu, 81739 München (DE); Lates, Cristina-Georgiana, 81739 München (DE)
(74) Representative: Continental Corporation

(57) **Abstract**

The invention concerns a cooling method, especially for a car and specifically an apparatus (16) for cooling a component (3),
especially a component (3) on a printed circuit board (10) for a vehicle, characterized in that the apparatus comprises a thermal diode (1) for transfer of heat from the component (3) to a heat sink (4).

## Description

The invention concerns a thermal diode, preferably with a coolant and a cooling method.

A vehicle may e.g. comprise one or several ECUs with at least one component that needs cooling.

It is an object of the invention to improve a cooling apparatus for a car, especially for cooling a component of an ECU for a car. The object is respectively achieved by the teaching of the independent patent claims.

According to the dependent patent claims, the invention also comprises embodiments that provide features which afford additional technical advantages:
Preferably the cooling apparatus comprises at least one layer, especially a thermal interface layer and/or thermal paste, between the thermal diode and the component and/or between the thermal diode and the heat sink.
Preferably in the cooling apparatus at least one layer is being compressed to a thinner layer thickness by expansion of the thermal diode and/or the component in a heated state of the thermal diode and/or of the component, i.e. in this state providing a smaller distance between the thermal diode and the component and/or heat sink.
Preferably the thermal diode comprises two zones, each comprising at least one of two component materials, wherein each material has a different thermal conductivity W/mK and/or coefficient of thermal expansion CTE.
Preferably the apparatus comprises a coolant, especially with channels for a coolant liquid that can be recirculated for active cooling.
Preferably the heat sink of the colling apparatus is an exterior component or cooling plate of a housing of the apparatus.

Preferably a component is located on a printed circuit board for or in a vehicle, The invention also concerns a vehicle and a cooling method.

The embodiments explained in the following are preferred embodiments of the invention. However, in the embodiments, the described components of the embodiments each represent individual features of the invention which are to be considered independently of each other and which each develop the invention also independently of each other and thereby are also to be regarded as an element of the invention in individual manner or in another than the shown combination. Furthermore, the described embodiments can also be supplemented by further features of the invention already described. In the figures elements that provide the same function are marked with identical reference signs.

In the following an exemplary implementation of the invention is described.
The figures show the following:
- Fig. 1: a cross section of a car with an ECU with a cooling apparatus,
- Fig. 2: an exploded view of a cooling apparatus, and
- Fig. 3: a cross section of a thermal diode in a cooling apparatus.

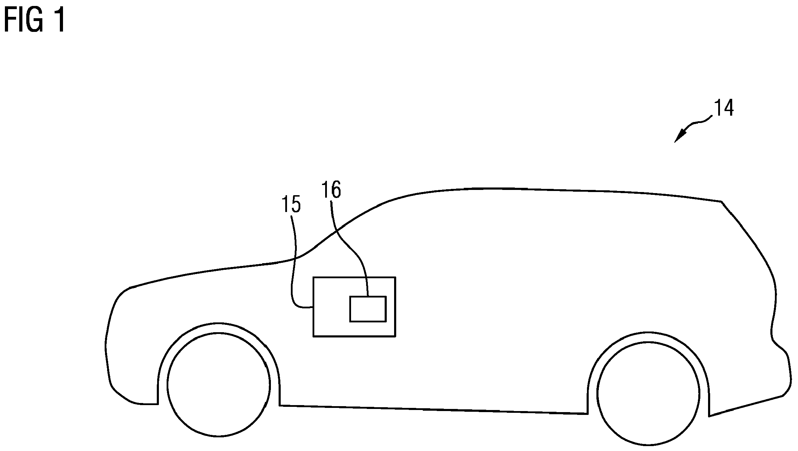

Fig. 1 shows a car 14 with an apparatus (i.e. device) 15 (e.g. an ECU = electronic control unit etc.) with one or several electrical components 3. Components 3 for automotive products as cars, especially ECUs' components and/or 4G/5G communication components 3 (receivers, transmitters, amplifiers, memory modules etc) might need cooling.

Embodiments of the invention may have cooling possibilities aiming to improve the heat transfer between a component 3 as a heat source and a heat sink (e.g. radiator) 4. e.g. by improving and/or increasing the area of conductive heat transfer and/or based on improved and/or increased surface contact due to the coefficient of thermal expansion of a material used in the construction of the device, especially a thermal diode 1.

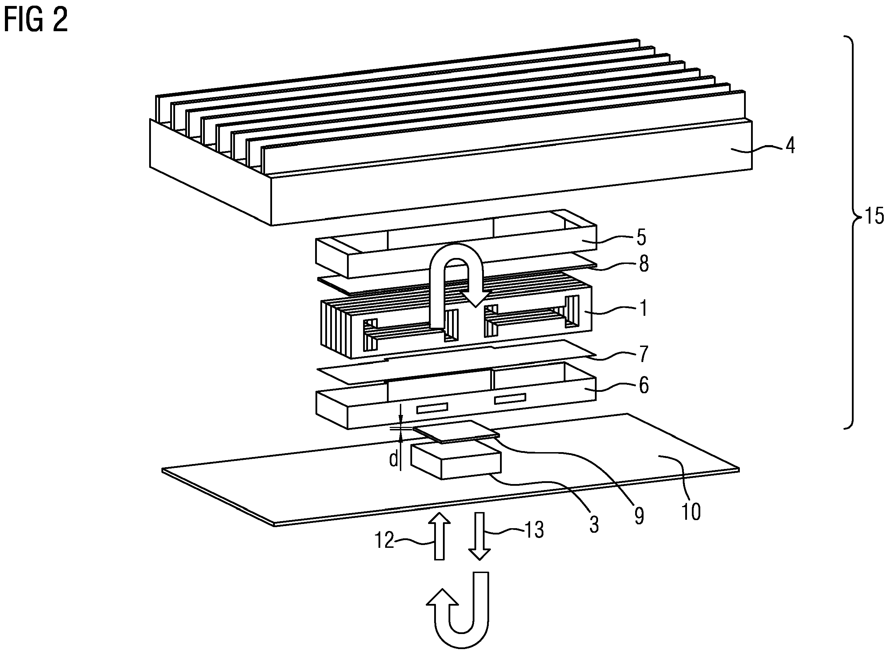

Fig 2 shows in an exploded view a cooling apparatus 15 (further also named thermal device or heat exchanger block), e.g. in an ECU 16, for cooling at least one electrical component 3 (e.g. processor, memory module, amplifier etc), which component 3 here is e.g. located on a printed circuit board (PCB) 10.

The cooling apparatus 15 here comprises two top and bottom half housings 5, 6.

In this cooling apparatus 15, a coolant 2, e.g. a liquid, can be used and recirculated (as arrows 12, 13 indicate) for active cooling, and/or a phase change material (PCM) and/or a thermal diode element 1 for passive cooling can be used. The coolant 2 can e.g. be circulated (12, 13) horizontally in Fig. 2 through two e.g. H- shaped slits in the element 1 and slits in the element 6 and trough further not shown elements. The coolant 2 can also be omitted, i.e. cooling e.g. can be performed only by a thermal diode between a component 3 and a heatsink 4. A phase change material, also called thermal diode 1 can be designed e.g. as explained in https://en.wikipedia.org/wiki/Thermal_diode.

The thermal device 1 can be in direct or indirect permanent contact with a heat source as e.g. a power loss of an electrical or electronic component 3 and with a cold (colder) heatsink 4 (with a lower temperature T1) as e.g. a dissipator and/or apparatus cover etc.

The thermal device in Fig. 2 e.g. is sealed from the component 3 to be cooled and from the heatsink 4 by two (top 8 and bottom 7 sides) membranes to avoid the leakage of the coolant 2.

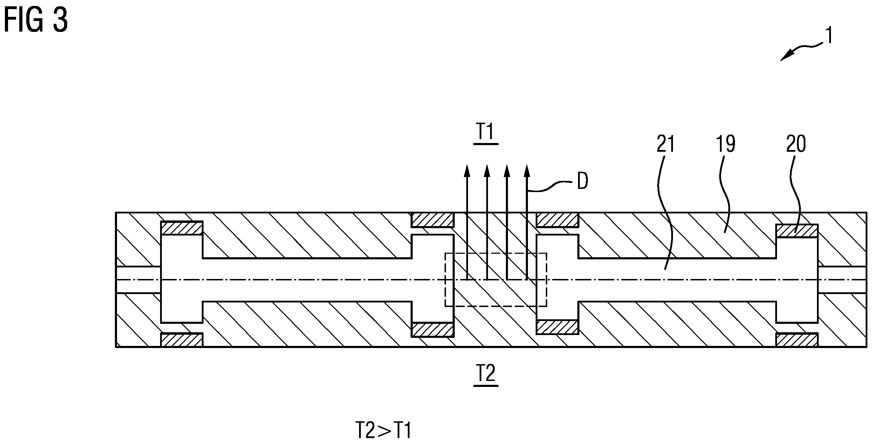

Fig. 3 shows an embodiment of the thermal device named here a thermal diode 1. A thermal diode 1 can have a special design structure, e.g. using dual-component materials, each material having its own different K conductivity (W/mK) and/or coefficient of thermal expansion CTE.

In Fig. 3 one part or parts (zones 19) of the thermal diode 1 can comprise a material with a higher conductivity K (W/mK) than the material in the other parts (zones 20) of the thermal diode 1 (thus having a lower relatively conductivity K (W/mK)).
In Fig. 3 one part or parts (zones 19) of the thermal diode 1 can comprise a material with a lower coefficient of thermal expansion (=CTE) than the material in one other part or parts (zones 20) of the thermal diode 1 (thus having a higher coefficient of thermal expansion (=CTE)).
A contact zone of the lower part of the thermal diode 1 and of the upper part of the thermal diode 1 can transfer heat in the direction of the arrows D in a zone 21.

In Fig. 3, the temperature in the lower part (which is more closed to the component 3 to be cooled) of the thermal diode 1 can have a higher temperature T2 (originating from the component 3) than the area in or above the upper part of the thermal diode 1 (T2>T1), especially in a (heat) forwarding operation (cooling) mode.

A mismatching of the K-CTE values of the bi-component material can create high level of mechanical stress-strain in the different areas' material which can lead to deformation of the thermal diode part. Due to these deformations the thermal diode can get in more direct contact with the heatsink 4 and/or with the electronic component 3 by reducing the thermal interface material (TIM) layer(s)' 9 thickness d and/or reducing the thermal resistances. Thus with increasing temperature of the electrical component 3, its cooling can e.g. be increased.

A thermal transfer can e.g. be done by one of the following two ways or both:
- In the moment that the electronic component 3 is overheated, there is a heat transfer from thermal diode 1 to coolant 2, e.g. in the steady-state as well as transient-state heat flow.
- The rest of the heat can be flowing through the component 3 to the thermal diode 1 contact and to the heatsink 4 due to an existing very low thermal resistance between these parts in contact.

Embodiments of the invention can improve cooling possibilities especially improving the heat transfer phenomenon between heat source 2 and radiator 4 by increasing the area of conductive heat transfer and/or based on surface contact or increased surface contact directly due to the coefficient of thermal expansion of the material used in the construction of the device, called the thermal diode 1.

The proposed apparatus or system can be a merely passive one and it may not need additional power supply, and no additional heating due to electric power consumptions. It can have more efficient cooling effects than air forced convection cooling. It can e.g. use a local (e.g. Al- or Aluminum -alloy) heatsink only, i.e. without need to design the housing as a whole heatsink. In case no possibility exists to use a liquid coolant recirculated, the device can just use the phase change materials (PCM) for cooling effects.

### Reference signs

- 1: thermal diode
- 2: coolant
- 3: component
- 4: heatsink
- 5: top (upper) half housing, insulating exterior
- 6: bottom (lower) half housing, insulating interior
- 7: insulating membrane 1
- 8: insulating membrane 2
- 9: thermal interface layer and/or thermal paste
- 10: printed circuit board PCB for a vehicle
- 11: heat conduction zone
- 12: coolant input
- 13: coolant output
- 14: car
- 15: apparatus (e.g. in ECU)
- 16: heat exchanger (block)
- 17: lower part of thermal diode
- 18: upper part of thermal diode
- 19: zone with low k, high CTE
- 20: zone with high k, low CTE
- T1: low temperature zone
- T2: high temperature zone
- Z: heat conduction zone
- D: heat transfer direction
- CTE: thermal expansion

## Claims

1. Apparatus (16) for cooling a component (3),
especially a component (3) on a printed circuit board (10) for a vehicle (14), **characterized in that** the apparatus comprises a thermal diode (1) for transfer of heat from the component (3) to a heat sink (4).

2. Apparatus according to claim 1,
**characterized by** a layer (9), especially a thermal interface layer and/or thermal paste, between the thermal diode (1) and the component (3).

3. Apparatus according to any of the proceeding claims,
**characterized by** a layer (9), especially a thermal interface layer and/or thermal paste, between the thermal diode (1) and the heat sink (4).

4. Apparatus according to any of the proceeding claims,
**characterized by** at least one layer (9) being compressed to a thinner layer (d) thickness by expansion of the thermal diode (1) in a heated state of the thermal diode (1),
compared to a cool state of the thermal diode (1) and/or of the component (3).

5. Apparatus according to any of the proceeding claims,
**characterized by** one or two layers (9) being compressed to a thinner layer thickness (d) by expansion of the component (3) in a heated state of the component (3),
compared to a cool state of the thermal diode (1) and/or of the component (3).

6. Apparatus according to any of the proceeding claims,
**characterized in that**
the thermal diode (1) comprises two zones (19,20), each comprising at least one different component material, wherein each material has a different thermal conductivity (W/mK) and/or coefficient of thermal expansion (CTE).

7. Apparatus according to any of the proceeding claims,
**characterized in that**
it comprises a circulated coolant (2), preferably a coolant liquid that can be recirculated for active cooling.

8. Apparatus according to any of the proceeding claims,
**characterized in that**
the heat sink (4) is an exterior element or cooling plate of a housing of the apparatus.

9. Vehicle (1) with an apparatus according to any of the proceeding claims, for cooling a component (3) that is an electrical or electronic component, especially a processor or memory module or amplifier or receiver or transmitter.

10. Method for cooling a component (3),
especially a component (3) on a printed circuit board (PCB, 10) for a vehicle,
**characterized in that** the apparatus uses a thermal diode (1) for transfer of heat from the component (3) to a heat sink (4).
